# EUROPEAN PATENT APPLICATION

(11) **EP 1 715 513 A1**
(43) Date of publication of application: **25.10.2006**
(21) Application number: 06006044.9
(22) Date of filing: 23.03.2006
(51) Int. Cl.: H01L 21/677, H01L 21/673

(54) **Airtight container**

(30) Priority: 24.03.2005 JP 2005086029
(71) Applicant: Miraial Co., Ltd., Tokyo (JP)
(72) Inventor: Kominami, Satoshi Miraial Co., Ltd., Tokyo (JP)
(74) Representative: Grünecker, Kinkeldey, Stockmair & Schwanhäusser Anwaltssozietät

(57) **Abstract**

A space is largely defined inside of a lid 14, thus enhancing the freedom of a design of members to be contained inside of the lid 14. An airtight container 11 includes a container unit 12 which contains therein a plurality of semiconductor wafers W, the lid 14 which closes the container unit 12, and a seal 74 which air-tightly seals a clearance defined between the container unit 12 and the lid 14. A support groove 41 is formed at an inside plate 30A of the lid 14 so as to support the semiconductor wafers W one by one. The support groove 41 is formed at the inside plate 30A of the lid 14 in such a manner as to be opened toward the container unit 12, and is constituted of a slit, at and into which the semiconductor wafers are fitted and supported one by one. A V-shaped groove 42 is formed at the bottom of the support groove 41. A support groove 61 having another configuration includes a relief groove 62 formed at the inside plate 30A, and a thin plate supporter 63 which is disposed in a manner corresponding to the relief groove 62 in a thin plate supporting space S defined between a cover plate 65 and the inside plate 30A, so as to support one by one the semiconductor wafers W fitted into the relief groove 62.

## Description

### BACKGROUND OF THE INVENTION

The present invention relates to an airtight container, in which a thin plate such as a semiconductor wafer, a storage disk or a liquid crystal glass substrate is contained, to be then stored, transported or used in a fabrication process.

There has been generally known an airtight container, in which a thin plate such as a semiconductor wafer is contained, to be then stored or transported.

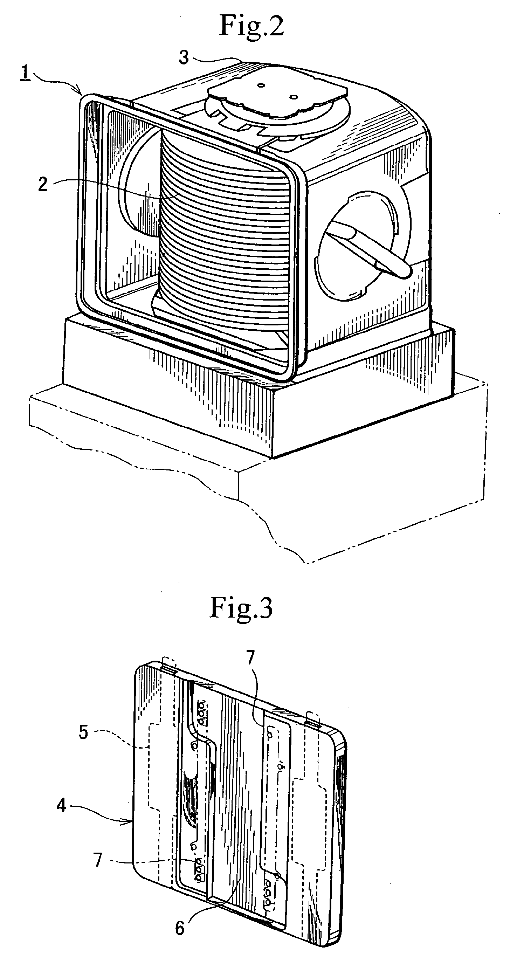

An airtight container in the related art is exemplified in FIGS. 2 and 3. In FIGS. 2 and 3, an airtight container 1 is a sealing container capable of holding a plurality of semiconductor wafers 2 therein in a horizontal manner. The airtight container 1 includes a container unit 3 which has a front opening and contains the plurality of semiconductor wafers 2 therein, and a door 4 which tightly closes the front opening of the container unit 3. The door 4 is constituted of a pair of inside latch mechanisms 5 disposed laterally on both sides, a cavity 6 formed at the center between the pair of inside latch mechanisms 5 in such a manner as to extend from above to below, and wafer supporters 7 disposed at the inside surface of the cavity 6.

The related art is disclosed in, for example, U.S. Patent No. 6,736,268.

The cavity 6 extending from above to below is formed at the center in the above-described door 4. The semiconductor wafer is located at the portion of the cavity 6. As a consequence, the inside latch mechanisms 5 are contained inside of the lid 1 in such a manner as to avoid the cavity 6. Therefore, a space for use in containing the inside latch mechanisms 5 becomes narrow, thereby raising a problem of a small freedom of a design.

### SUMMARY OF THE INVENTION

The present invention has been accomplished to solve the above-described problems. Therefore, an object of the present invention is to provide an airtight container, in which a space is largely defined inside of the lid, thus enhancing the freedom of a design of members to be contained inside of the lid.

In order to achieve the above-described object, according to the present invention, an airtight container, including a container unit which contains therein a plurality of thin plates; a lid which closes the container unit; and a seal member which seals a clearance defined between the container unit and the lid; includes a support groove which is formed at an inside surface of the lid so as to support the thin plates one by one or every two or more.

The lid includes an upper plate for covering an upper side, a lower plate for covering a lower side and a machine interface formed at a clearance which is defined between the upper plate and the lower plate and is opened outward; wherein the support groove includes a relief groove which is intermittently formed at the lower plate and partly penetrates through the lower plate, and a thin plate supporter which is disposed in a manner corresponding to the relief groove in a thin plate supporting space air-tightly separated from the outside and opened toward the relief groove at a clearance defined between the upper plate and the lower plate so as to support one by one the thin plates fitted into the relief groove. The thin plate supporting space defined between the upper plate and the lower plate is air-tightly separated from the outside via a seal member disposed at a clearance between the upper plate and the lower plate.

Alternatively, the support groove having another configuration is formed at the inside surface of the lid in such a manner as to be opened toward the container unit, and is constituted of a slit, at and into which the thin plates are supported and fitted one by one or every two or more. A V-shaped groove for fitting and supporting the thin plate is formed at the bottom of the slit.

As described above, in the airtight container according to the present invention, the thin plates contained inside of the container unit are fitted into the support grooves formed at the inside surface of the lid, to be thus supported thereat. Thus, the space is largely defined inside of the lid, thereby enhancing the freedom of the design of the members to be contained inside of the lid.

### BRIEF DESCRIPTION OF THE DRAWINGS

FIG. 1 is a bottom view showing a lid in an airtight container in a preferred embodiment according to the present invention;
FIG. 2 is a perspective view showing a conventional airtight container;
FIG. 3 is a perspective view showing a lid in the conventional airtight container;
FIG. 4 is a perspective view showing a container unit in the airtight container in the preferred embodiment according to the present invention;
FIG. 5 is a perspective view showing the lid in the airtight container in the preferred embodiment according to the present invention;
FIG. 6 is a perspective view showing essential parts of the container unit in the airtight container in the preferred embodiment according to the present invention;
FIG. 7 is a perspective view showing essential parts of the lid in the airtight container in the preferred embodiment according to the present invention;
FIG. 8 is a perspective view showing the essential parts of the lid in the airtight container in the preferred embodiment according to the present invention;
FIG. 9 is a cross-sectional view showing the essential parts of the lid in the airtight container in the preferred embodiment according to the present invention;
FIG. 10 is a cross-sectional view showing essential parts in a first modification of the preferred embodiment according to the present invention;
FIG. 11 is a cross-sectional view showing essential parts in a second modification of the preferred embodiment according to the present invention;
FIG. 12 is a cross-sectional view showing essential parts in a third modification of the preferred embodiment according to the present invention;
FIG. 13 is another cross-sectional view showing the essential parts in the third modification of the preferred embodiment according to the present invention;
FIG. 14 is a perspective view showing a thin plate presser in the third modification of the preferred embodiment according to the present invention;
FIG. 15 is a bottom view showing a lid in the third modification of the preferred embodiment according to the present invention;
FIG. 16 is a plan view showing a fourth modification of the preferred embodiment according to the present invention;
FIG. 17 is a cross-sectional view showing essential parts in a fifth modification of the preferred embodiment according to the present invention; and
FIG. 18 is another cross-sectional view showing the essential parts in the fifth modification of the preferred embodiment according to the present invention.

### DESCRIPTION OF THE PREFERRED EMBODIMENTS

A description will be given below of a preferred embodiment according to the present invention referring to the attached drawings. An airtight container according to the present invention is a container, in which a thin plate such as a semiconductor wafer, a storage disk or a liquid crystal glass substrate is contained, to be then stored, transported or used in a fabrication process. Here, the present invention is exemplified by an airtight container which contains therein semiconductor wafers.

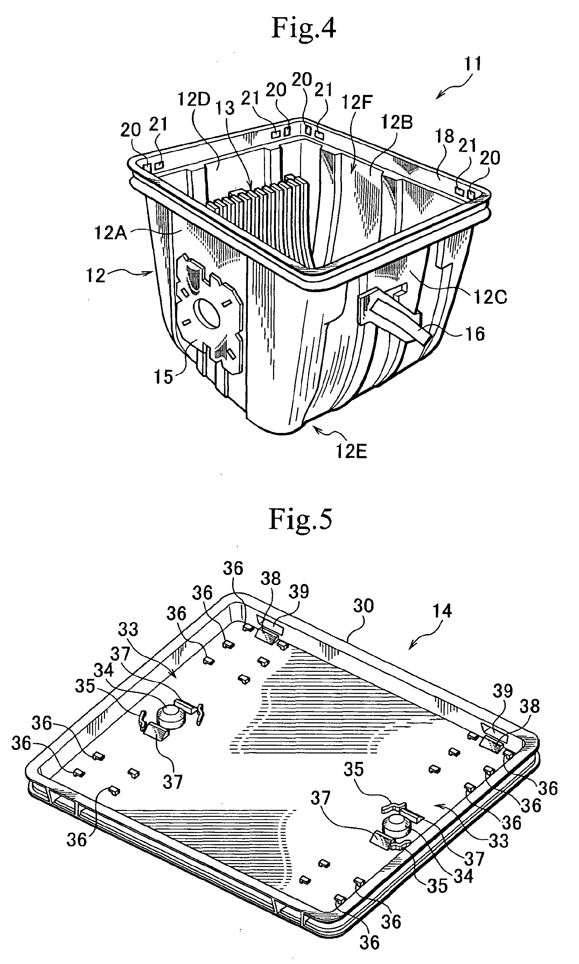

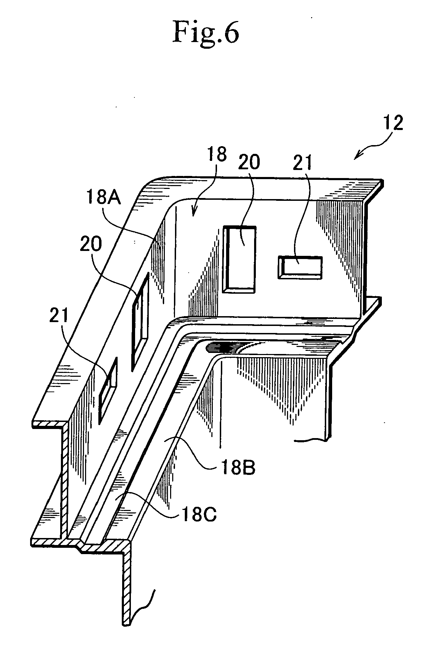

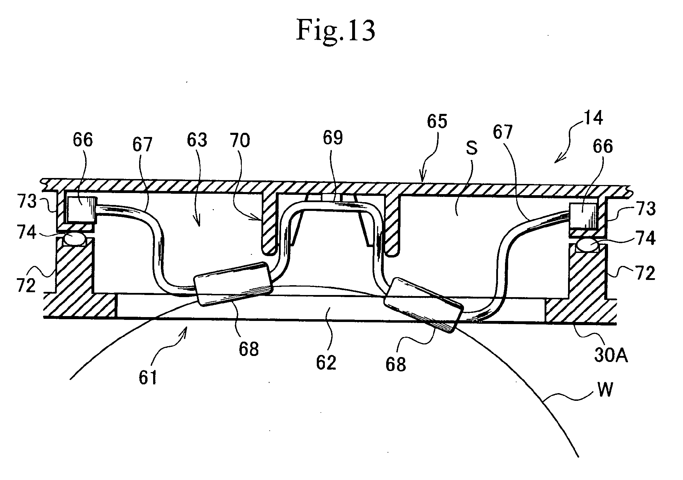

As shown in FIGS. 4 and 5, an airtight container 11 in the present preferred embodiment includes a container unit 12 which contains a plurality of semiconductor wafers W (see FIG. 13) therein; two thin plate supporters 13 which are disposed on side walls opposite to each other inside of the container unit 12 so as to support, on both sides; the semiconductor wafers W contained inside of the container unit 12; a lid 14 which covers the container unit 12; a top flange 15 which is grasped by an arm of a conveyor (not shown) in a factory; and carrying grips 16 which are gripped by a worker when the airtight container 11 is manually carried by the worker.

The container unit 12 is formed into a cubic shape as a whole. The container unit 12 is constituted of four side walls 12A, 12B, 12C and 12D and a bottom plate 12E serving as peripheral walls and has an opening 12F formed at an upper portion thereof in a vertically set state (i.e., in a state shown in FIG. 4). When the container unit 12 is installed in a manner facing to a wafer conveying robot (not shown) in a fabrication line of the semiconductor wafer W, or the like, the container unit 12 is laterally set. Outside of the side wall 12B serving as a bottom in the laterally set state is disposed a positioning means (not shown) for the airtight container 11. Outside of the side wall 12A serving as a top in the laterally set state is detachably attached the top flange 15. Outside of the side walls 12C and 12D serving as lateral walls in the laterally set state are detachably attached the carrying grips 16.

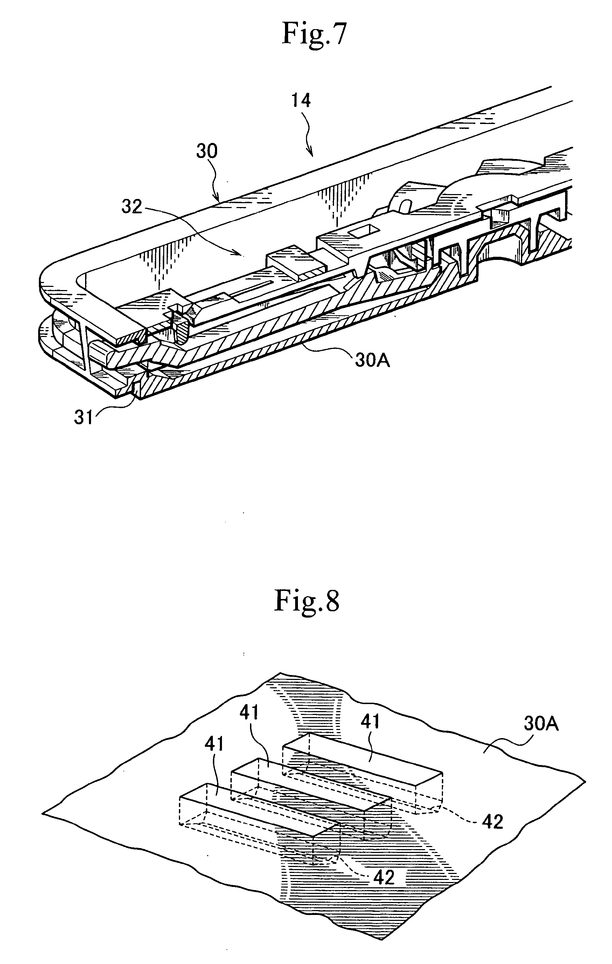

As shown in FIGS. 4, 6 and 7, a lid receiver 18, to which the lid 14 is fitted, is disposed at an upper end of each of the side walls 12A, 12B, 12C and 12D of the container unit 12 in the vertically set state. The lid receiver 18 is formed by enlarging the upper end of the container unit 12 to the dimension of the lid 14. As a consequence, the lid 14 is adapted to be fitted to the inside of a vertical plate 18A of the lid receiver 18 and to abut against a horizontal plate 18B, to be thus fixed to the lid receiver 18. Furthermore, at the entire circumference of the horizontal plate 18B is formed a seal groove 18C, to which a gasket (not shown) fixed at the lower side surface of the lid 14 is fitted to air-tightly seal the inside of the airtight container 11. At the inside surface of the vertical plate 18A constituting four corners of the lid receiver 18 are formed first fitted portions 20 for fixing the lid 14 onto a side of the container unit 12 in engagement with a locking member of a simplified attaching/detaching mechanism 32, described later. The first fitted portion 20 is formed by engraving the vertical plate 18A into a rectangular shape. A lid locking member of the simplified attaching/detaching mechanism 32 is designed to be fitted at an upper surface inside of the first fitted portion 20.

Moreover, a second fitted portion 21 is formed in the vicinity of each of the first fitted portions 20. The second fitted portions 21 are fitted with a simplified attaching/detaching mechanism for the lid, having another structure.

As shown in FIGS. 5 to 8, the lid 14 includes a main body 30, a cover plate (not shown) and the simplified attaching/detaching mechanism 32.

The main body 30 is a lower plate for covering the lower side, and is formed into a shallow dish of a substantial rectangle. An inside plate 30A serving as a bottom plate of the main body 30 and a cover plate serving as an upper plate for covering the upper side of the main body 30 define therein a wide space for supporting the thin plate. Around a lower portion of the main body 30 is secured a gasket receiver 31. At the gasket receiver 31 is received the gasket, which is fitted to the seal groove 18C in a state in which the main body 30 is disposed in the lid receiver 18 of the container unit 12, thereby sealing the inside of the container unit 12.

At ends on both sides in a lateral direction in the main body 30 of the lid 14 (i.e., on both sides in upper left and lower right directions in FIG. 5) are provided disposing portions 33, to which the simplified attaching/detaching mechanism 32 is fixed, respectively. At the disposing portion 33 are provided rotary support shafts 34, stoppers 35, locking claws 36, base end lower cams 37, tip cams 38 and the like. At both ends in a lengthwise direction at the disposing portion 33 (i.e., at both ends in upper right and lower left directions in FIG. 5) are formed openings 39, into or from which the locking members of the simplified attaching/detaching mechanism 32 are inserted or detached.

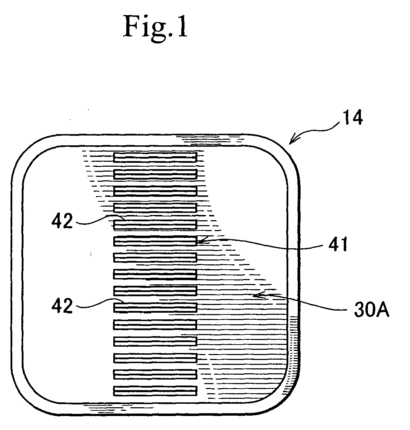

Inside of the inside plate 30A of the lid 14 (i.e., on the side of the container unit 12) are formed support grooves 41 for supporting the semiconductor wafers W one by one, as shown in FIGS. 1, 8 and 9. The support groove 41 is constituted of a slit opened toward the container unit 12 at the inside plate 30A. The plurality of elongated support grooves 41 are formed in parallel to each other (in the same number as that of semiconductor wafers W contained inside of the container unit 12). The support grooves 41 are located at intervals of the semiconductor wafers W contained inside of the container unit 12. The semiconductor wafers W are fitted into the support grooves 41 one by one, to be thus supported therein. At the bottom of the support groove 41 is formed a V-shaped groove 42, which positions and supports the semiconductor wafer W fitted with the edge of the semiconductor wafer W. Here, the thickness of the inside plate 30A is set according to the depth of the support groove 41. A projection protruding according to the depth of the support groove 41 may be formed at the upper surface corresponding to the support groove 41 at the inside plate 30A.

The airtight container 11 such configured as described above is used in the following manner.

The semiconductor wafers W are contained inside of the container unit 12, to be then covered with the lid 14. At this time, the lid 14 is fitted in the lid receiver 18 in the container unit 12, and then, is fixed to the container unit 12 by the simplified attaching/detaching mechanism 32. Here, the upper edge of each of the semiconductor wafers W contained inside of the container unit 12 is fitted to the corresponding support groove 41 on the side of the inside plate 30A of the lid 14. In addition, the upper edge of each of the semiconductor wafers W is fitted to the V-shaped groove 42 at the back of the support groove 41, to be thus fixed and supported in a precisely positioned state.

As described above, the airtight container 11 can produce the following effects:
(1) Since the support grooves 41 for supporting the semiconductor wafers W one by one are formed at the inside plate 30A in the lid 14, a wide space can be secured inside of the lid 14, and therefore, a mechanism such as the simplified attaching/detaching mechanism 32 can be disposed without any restriction from the viewpoint of the space. As a consequence, it is possible to enhance the freedom of the design of the simplified attaching/detaching mechanism 32, and further, to dispose other devices.
(2) Since the support grooves 41 are formed at the inside plate 30A in the lid 14 in such a manner as to be opened toward the container unit 12, the space defined inside of the lid 14 cannot be narrowed without any large intrusion into the lid 14, thereby securing the wide space. As a result, it is possible to enhance the freedom of the design, and further, to dispose other devices, as described above.
(3) Since the V-shaped groove 42 is formed at the bottom of the support groove 41, the edge of the semiconductor wafer W can be fitted into the V-shaped groove 42, to be thus stably supported therein.

### [Modifications]

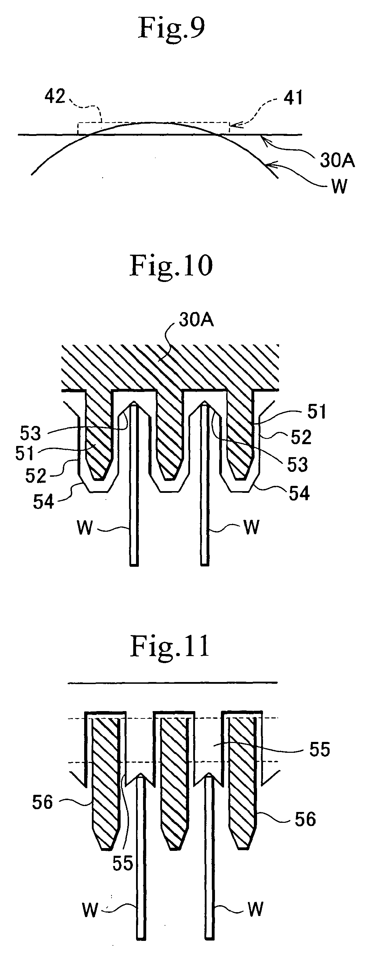

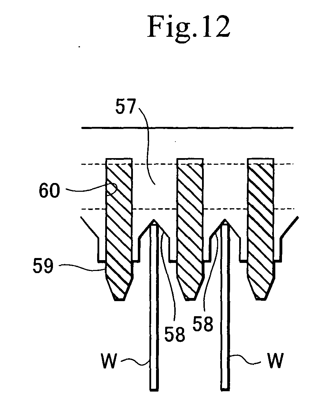

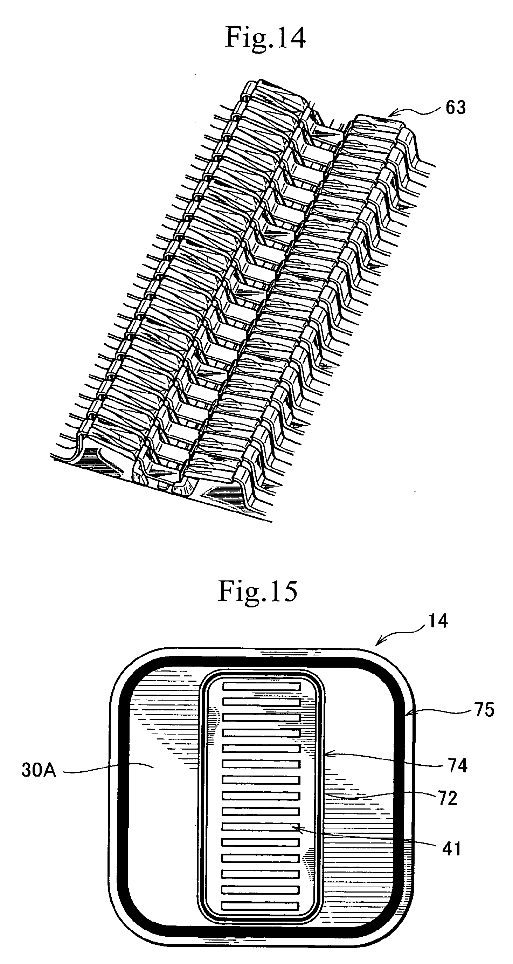

(1) Although the above-described preferred embodiment is configured such that one semiconductor wafer W is fitted into and supported by one support groove 41, it may be configured such that the plurality of semiconductor wafers W are fitted into and supported by one support groove 41. In this case, V-shaped grooves are formed in parallel to each other at the bottom of the support groove 41 in the same number as that of semiconductor wafers W to be fitted.
(2) Although each of the right and left edges of the support groove 41 is formed at a right angle in the above-described preferred embodiment, each of the right and left edges of the support groove 41 may be tapered (with a taper similar to a taper 54 shown in FIG. 10) such that the semiconductor wafer W can be readily fitted into the support groove 41.
(3) A plurality of partition plates 51 in FIG. 10 are made of plate members arranged in parallel to each other toward the container unit 12 in the inside plate 30A in the lid 14. The partition plates 51 are molded integrally with the inside plate 30A. An intermediate member 52 is interposed between the partition plates 51, thereby forming the V-shaped groove. The intermediate member 52 is made of a synthetic resin having elasticity, and further, is such configured as to cover each of the partition plates 51. Specifically, the support grooves mating with the partition plates 51 are formed in the same number as that of partition plates 51, and further, V-shaped grooves 53 are formed between the support grooves in order to receive the semiconductor wafer W therein in a direction reverse to the support groove and support it thereby. At the tip of the intermediate member 52 is formed the taper 54. The taper 54 is adapted to allow the semiconductor wafer W to be readily fitted into the V-shaped groove 53. The intermediate member 52 is fixed in such a manner as to cover each of the partition plates 51 and inserted between the partition plates 51 under pressure. The intermediate member 52 is molded with PEEK or PET. The partition plate 51 is molded with the same PC as that of the inside plate 30A. Thus, this modification can produce the same functions and effects as those produced in the above-described preferred embodiment.
   Incidentally, although the intermediate member 52 is inserted between the partition plates 51 under pressure in the above-described modification, an intermediate member 55 and a partition plate 56 may be arranged with a clearance therebetween, as shown in FIG. 11. In this case, both of the intermediate member 55 and the partition plate 56 may be formed integrally with the inside plate 30A. At this time, it is important at least to tightly weld or integrally mold the outside surface of the inside plate 30A and the peripheral edge of the intermediate member 55 in such a manner as to air-tightly seal a gap defined between the container unit and the outside. The formation of the clearance between the intermediate member 55 and the partition plate 56 can allow the intermediate member 55 to be softly flexed so as to more elastically support the semiconductor wafer W.
   Alternatively, as shown in FIG. 12, the intermediate member 57 may include the V-shaped grooves 58 formed according to the arrangement intervals of the semiconductor wafers W and the partition plate support grooves 60, which are formed between the V-shaped grooves 58 and into which partition plates 59 are securely inserted and fixed under pressure. In this case, the intermediate member 57 may be molded either integrally with or independently of the inside plate 30A. In the case where the intermediate member 57 is molded independently of the inside plate 30A, the intermediate member 57 may be bonded to the inside plate 30A via an adhesive agent or the like. Here, the tip of the partition plate 59 is tapered in order to achieve smooth insertion or withdrawal of the semiconductor wafer W.
(4) Although the support groove is elongated at the inside plate in the lid in the above-described preferred embodiment, it may be configured as shown in FIGS. 13 to 15. Here, a support groove 61 includes a relief groove 62, which communicates intermittently with the inside plate 30A and partly with the inside of the container unit 12 and penetrates through the inside plate 30A, and a thin plate supporter 63, which is disposed in a manner corresponding to the relief groove 62 in a thin plate support space S opened toward the relief groove 62 in airtight separation from the outside in the clearance defined between a cover plate 65 and the inside plate 30A so as to support one by one the semiconductor wafers W fitted to the relief grooves 62.

The relief groove 62 has a hole formed at the inside plate 30A in the lid 14, to thus allow the plurality of semiconductor wafers W to be inserted. thereinto one by one or every two or more. The lateral width of the relief groove 62 is set according to the number of semiconductor wafers W to be inserted. The number of relief grooves 62 is determined according to the number of semiconductor wafers W to be contained. The relief grooves 62 are formed in parallel to each other in the number such determined as described above. Incidentally, in the case where the plurality of semiconductor wafers W are contained in one relief groove 62, the relief grooves 62 are arranged in parallel to each other in the number accordingly.

The thin plate supporter 63 is a member for fitting and supporting the semiconductor wafer W inserted through the relief groove 62. The thin plate supporter 63 is secured to the cover plate 65 for covering the upper side of the lid 14. The thin plate supporter 63 mainly includes a base end supporter 66, an elastic support plate 67, an abutting piece 68, a connecting support plate 69 and a supporting rib 70. The semiconductor wafer W is fitted at the edges thereof to two abutting pieces 68, to be thus supported thereby. The two abutting pieces 68 are disposed in a manner corresponding to the relief groove 62, and therefore, support one by one the semiconductor wafers W fitted into the relief groove 62. The abutting piece 68 is elastically supported on both sides thereof by the elastic support plate 67 and the connecting support plate 69, thereby elastically supporting the semiconductor wafer W. In particular, the connecting support plate 69 is supported by the supporting rib 70 disposed at the cover plate 65, and therefore, stably supports the two abutting pieces 68. Consequently, the two abutting pieces 68 stably supported by the connecting support plate 69 supported by the supporting rib 70 elastically support the semiconductor wafer W. Incidentally, the thin plate supporter 63 may be divided into a plurality of parts. That is to say, the thin plate supporter 63 may be appropriately divided according to fixing modes.

In the case where the relief groove 62 is formed at the inside plate 30A in the lid 14, the container unit 12 need be sealed in order to be shut off from outside air. In view of this, a seal receiving wall 72 is provided at the inside plate 30A in such a manner as to surround the relief groove 62. In addition, a hook supporter 73 for supporting the base end supporter 66 of the thin plate supporter 63 is provided at the cover plate 65. The hook supporter 73 faces to the seal receiving wall 72. An annular seal 74 is interposed between the hook supporter 73 and the seal receiving wall 72, thereby air-tightly sealing the surroundings of the thin plate supporter 63. A space around the thin plate supporter 63 air-tightly sealed by the seal 74 serves as the thin plate support space, which is air-tightly separated from the outside and is opened toward the relief groove 62. Here, reference numeral 75 designates another seal for air-tightly sealing a gap defined between the container unit 12 and the lid 14. The two seals 74 and 75 air-tightly seal the inside of the container unit 12 from the outside.

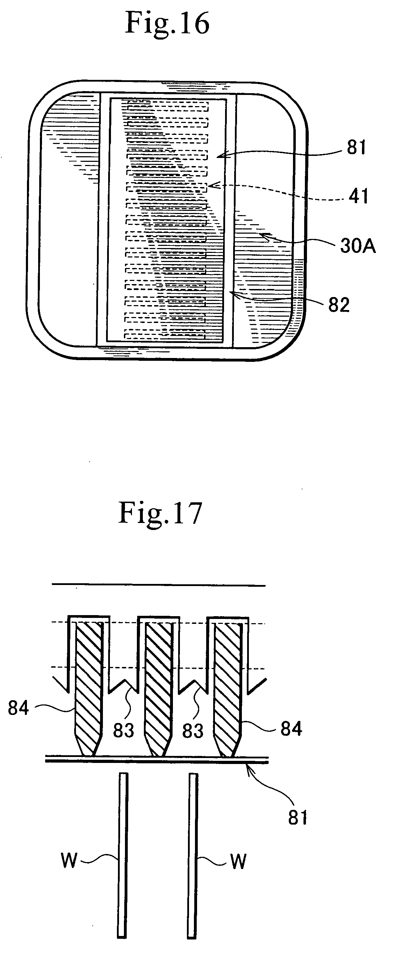

Although in the above-described case, the thin plate support space defined around the thin plate supporter 63 is air-tightly separated from the outside via the seal 74, the seal 74 may be replaced with an elastic film 81, as shown in FIG. 16. The elastic film 81 is attached in such a manner as to cover all of the support grooves 41, and then, is fixed via an elastic film presser 82. As a consequence, even if the thin plate support space is opened to the outside, the outside air cannot intrude into the container unit 12 through the support groove 41.

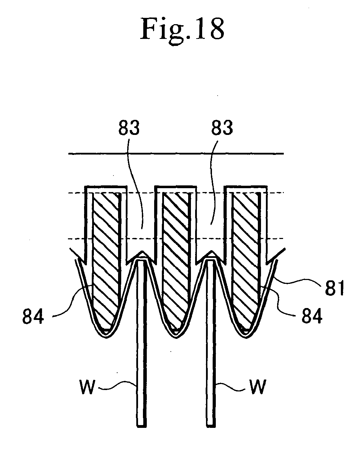

Otherwise, the elastic film 81 may be attached in such a manner as to cover all of the partition plates, as shown in FIGS. 17 and 18. An intermediate member 83 and a partition plate 84 shown in FIGS. 17 and 18 are members similar to the intermediate member 55 and the partition plate 56 shown in FIG. 11. The elastic film 81 is attached in such a manner as to cover all of the partition plates 84, and then, is fixed via the elastic film presser 82. As a consequence, when the semiconductor wafer W is inserted in the state in which all of the partition plates 84 are covered with the elastic film 81, as shown in FIG. 17, the semiconductor wafer W flexes the elastic film 81, which thus abuts against the intermediate member 83, as shown in FIG. 18. Consequently, the semiconductor wafer W can be elastically supported in the state in which the inside of the container unit 12 is air-tightly sealed.

The elastic film 81 is made of an expandable synthetic resin in such a manner as to be greatly flexed, as shown in FIG. 18. Specifically, the elastic film 81 is made of polyurethane, a silicone rubber film or the like.

In this case, the elasticity of the elastic film 81 may be adjusted by changing the material or thickness of the elastic film 81, thereby varying force supporting the semiconductor wafer W. The force supporting the semiconductor wafer W can be readily changed according to various conditions such as the size or conveyance mode of the semiconductor wafer W by adjusting the elasticity of the elastic film 81. In other words, an optimum supporting force can be readily achieved by adjusting the force supporting the semiconductor wafer W.

This modification also can produce the same functions and effects as those produced in the above-described preferred embodiment.

## Claims

1. An airtight container including a container unit which contains therein a plurality of thin plates, a lid which closes the container unit, and a seal member which seals a clearance defined between the container unit and the lid, the airtight container comprising:
a support groove which is formed at an inside surface of the lid so as to support the thin plates one by one or every two or more.

2. The airtight container according to claim 1, wherein the lid includes an upper plate for covering an upper side, a lower plate for covering a lower side, and a machine interface formed at a clearance which is defined between the upper plate and the lower plate and is opened outward; and
the support groove includes a relief groove which is intermittently formed at the lower plate and partly penetrates through the lower plate, and a thin plate supporter which is disposed in a manner corresponding to the relief groove in a thin plate supporting space air-tightly separated from the outside and opened toward the relief groove at a clearance defined between the upper plate and the lower plate so as to support one by one the thin plates fitted into the relief groove.

3. The airtight container according to claim 2, wherein the thin plate supporting space defined between the upper plate and the lower plate is air-tightly separated from the outside via a seal member disposed at a clearance between the upper plate and the lower plate.

4. The airtight container according to claim 1, wherein the support groove is formed at the inside surface of the lid so as to support the plurality of thin plates one by one, the support groove including a plurality of partition plates formed in parallel to each other at an inside plate of the lid toward the container unit, and an intermediate member located between the partition plates and forming a V-shaped groove; and
the intermediate member is interposed between the partition plates with a clearance.

5. The airtight container according to claim 1, wherein the support groove is formed at the inside surface of the lid in such a manner as to be opened toward the container unit, and is constituted of a slit, at and into which the thin plates are supported and fitted one by one or every two or more.

6. The airtight container according to claim 5, wherein the container unit is air-tightly separated from the outside via an expandable elastic film, which is air-tightly fixed at the surface of the relief groove.

7. The airtight container according to claim 6, wherein V-shaped grooves are formed at the bottom of the slit in the same number as that of thin plates to be fitted.

8. The airtight container according to claim 1, wherein the support groove includes a plurality of partition plates, which are formed in parallel to each other at an inside surface of the lid toward the container unit, and an intermediate member which is located between the partition plates and forms a V-shaped groove.

9. The airtight container according to claim 8, wherein the intermediate member is made of a synthetic resin having elasticity and is inserted between the partition plates under pressure.

10. The airtight container according to claim 8, wherein the intermediate member is made of a synthetic resin having elasticity and is inserted between the partition plates with a clearance.

11. An airtight container including a container unit which contains therein a plurality of thin plates, and a lid which closes the container unit, the airtight container comprising:
a support groove which is formed at the inside surface of the lid so as to support the plurality of thin plates one by one, the support groove including a plurality of partition plates formed in parallel to each other toward the container unit and an intermediate member located between the partition plates and forming a V-shaped groove,
the intermediate member including V-shaped grooves formed in a manner corresponding to clearances defined between the thin plates, and a partition plate supporting groove, which is formed between the V-shaped grooves and into which the partition plate is inserted under pressure, to be fixed thereto.

12. An airtight container including a container unit which contains therein the plurality of thin plates, and the lid which closes the container unit, the airtight container comprising:
the support groove which is formed at an inside surface of the lid so as to support the thin plates one by one or every two or more,
the support groove including a slit which is formed at an inside plate of the lid and into which the plurality of thin plates are fitted one by one or every two or more, and a thin plate presser housed inside of the lid for fitting and supporting the thin plates inserted through the slits.
